(19) Europäisches Patentamt
European Patent Office
Office européen des brevets

(11) **EP 3 156 913 B1**

(12) **EUROPEAN PATENT SPECIFICATION**

(45) Date of publication and mention of the grant of the patent:
**31.08.2022 Bulletin 2022/35**

(21) Application number: **15190320.0**

(22) Date of filing: **17.10.2015**

(51) International Patent Classification (IPC):
**G06F 17/10** (2006.01)  **G05B 23/02** (2006.01)
**G06K 9/62** (2022.01)

(52) Cooperative Patent Classification (CPC):
**G06F 17/10; G06K 9/6247;** G06F 30/20;
G06F 30/23

(54) **A METHOD FOR EVALUATING A PLURALITY OF DATA AGGREGATIONS, A METHOD FOR CALIBRATING A FINITE ELEMENT MODEL USING MEASURED DATA POINTS AND A METHOD FOR STORING A PLURALITY OF SIMULATIONS**

VERFAHREN ZUR BEWERTUNG EINER MEHRZAHL VON DATENAGGREGATIONEN, VERFAHREN ZUR KALIBRIERUNG EINES FINITE-ELEMENT-MODELLS MITTELS GEMESSENER DATENPUNKTE UND VERFAHREN ZUR SPEICHERUNG MEHRERER SIMULATIONEN

PROCÉDÉ PERMETTANT D'ÉVALUER UNE PLURALITÉ D'AGRÉGATIONS DE DONNÉES, PROCÉDÉ D'ÉTALONNAGE D'UN MODÈLE D'ÉLÉMENTS FINIS UTILISANT DES POINTS DE DONNÉES DE MESURE ET PROCÉDÉ PERMETTANT DE STOCKER UNE PLURALITÉ DE SIMULATIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.04.2017 Bulletin 2017/16**

(73) Proprietor: **Fraunhofer-Gesellschaft zur Förderung der angewandten Forschung e.V.**
**80686 München (DE)**

(72) Inventors:
• **Iza-Teran, Victor-Rodrigo**
  **53757 St. Augustin (DE)**
• **Garcke, Jochen**
  **53111 Bonn (DE)**

(74) Representative: **2SPL Patentanwälte PartG mbB**
**Landaubogen 3**
**81373 München (DE)**

(56) References cited:
**US-A1- 2004 196 287**

• **Rodrigo Iza Teran: "ENABLING THE ANALYSIS OF FINITE ELEMENT SIMULATION BUNDLES", International Journal for Uncertainty Quantification, 2014, pages 95-110, XP055259750, DOI: 10.1615/Int.J.UncertaintyQuantification.20 13005436 Retrieved from the Internet: URL:http://www.dl.begellhouse.com/download /article/4a19c3436c94ddb4/IJUQ0402(1)-5436 .p df [retrieved on 2016-03-18]**
• **LIU XIANG ET AL: "Compressed data aggregation", IEEE / ACM TRANSACTIONS ON NETWORKING, IEEE / ACM, NEW YORK, NY, US, vol. 21, no. 6, December 2013 (2013-12), pages 1722-1735, XP058045582, ISSN: 1063-6692, DOI: 10.1109/TNET.2012.2229716**
• **SORKINE OLGA: "Laplacian mesh processing", INTERNET CITATION, 2 September 2005 (2005-09-02), pages 1-18, XP002628807, Retrieved from the Internet: URL:http://cs.nyu.edu/~sorkine/ProjectPage s/Editing/STAR68.pdf [retrieved on 2011-03-17]**

**Description**

**Field**

The present disclosure relates to evaluating data aggregations in a lower dimensional space. In particular, embodiments relate to a method for calibrating a finite element model using measured data points.

**Background**

Data analysis is a challenging task in many technical fields. For example, data analysis is mandatory for condition monitoring of assemblies (e.g. condition monitoring of bearings or rotor blades). Another important field relying on data analysis is engineering. For example, the analysis of simulations used for virtual product development is essential nowadays. The simulations allow an engineer to simulate the behavior of a product on the basis of a detailed mathematical model solved numerically on a computer. Hence, the creation of physical models or prototypes may be avoided. However, the product development process demands the creation of several hundred or thousand models which may contain changes in geometry, material parameters, load conditions, type of connections between the parts of the models, etc.

Selecting a design that fulfills functional constraints and / or manufacturing conditions requires careful engineering judgment and is a time consuming process. Often previous valuable design decisions are not used because they are not available or because - if available - they correspond to other designs that are considered to be not related to the actual one.

Also the detection of errors and / or the influence of the interaction of many design parameters is commonly not well developed or understood. Conventional design processes are based on the use of reduced metadata - inhibiting a detailed analysis of simulations.

In Rodrigo Iza Teran: Enabling the analysis of finite element simulation bundles, International Journal of Uncertainty Quantification, 2014, pages 95-110 a methodology capable of allowing fast evaluation of thousands of finite element design variants simultaneously is proposed. The approach uses diffusion maps.

Shortening product development cycles, learning from previous designs, identifying trends or analyzing the interaction of many parameters are only a few aspects that require efficient and detailed analysis of available data. Hence, there may be a desire for a new analysis approach.

**Summary**

The present invention relates to a computer executed method as claimed in claim 1and a corresponding computer program as claimed in claim 4. Preferred embodiments are defined in the dependent claims.

An embodiment relates to a method for calibrating a finite element model using measured data points. The finite element model indicates a deformation of a physical object caused by the exertion of force to the physical object. The method comprises generating a plurality of simulations of the physical object using the finite element model based on varying sets of input parameters. A simulation comprises a plurality of data points representing numerical solutions of the finite element model. Further, the method comprises calculating a mathematical operator for one of the plurality of simulations based on a metric for the data points of the one simulation, wherein the mathematical operator defines a transformation that preserves the metric. The metric describes a distance between the individual data points of the one simulation. The method further comprises calculating eigenvectors of the mathematical operator, and projecting the remaining simulations of the plurality of simulations into a space spanned by the eigenvectors. Further, the method comprises calculating a synthetic space point in the space by interpolating at least two space points corresponding to the simulations projected into the space, and generating a synthetic simulation using an approximation for the finite element model based on the synthetic space point. The method further comprises determining a distance between the synthetic simulation and the measured data points. Either the transformation is an isometric transformation and the mathematical operator is a Laplace-Beltrami operator or the transformation is a non-linear transformation and the mathematical operator is a non-linear independent component analysis operator or a Fokker-Planck operator. Calculating a synthetic space point in the space, generating a synthetic simulation and determining a distance between the synthetic simulation and the measured data points is carried out iteratively until the determined distance satisfies a quality criterion.

The method may allow to determine a synthetic simulation based on the underlying finite element model that fits best to the measured data. The determined synthetic simulation is based on an approximation of the finite element model and the interpolated space point. The space point may allow to adjust simulation parameters for the synthetic simulation in a facilitated manner based on the simulations used for interpolating the space point. Based on the parameters of the best generated synthetic simulation, a regular simulation may be generated. Accordingly, a computational complexity may be reduced compared iteratively generating regular simulations and comparing them to the measured data points. Hence, an overall computational effort for determining a simulation that fits best to the measured data points may be reduced compared to conventional approaches. Hence, reduced effort for calibrating a finite element model with real data may be allowed.

Another embodiment relates to computer program having a program code configured to perform the method for calibrating a finite element model, when the computer program is executed on a computer or processor.

**Brief description of the Figures**

Some embodiments of apparatuses and/or methods will be described in the following by way of example only, and with reference to the accompanying figures, in which

Fig. 1 illustrates a flowchart of an embodiment of a method for evaluating a plurality of data aggregations;

Fig. 2a illustrates an example of a data aggregation;

Fig. 2b illustrates an example of a space comprising a plurality of projected data aggregations;

Fig. 3 illustrates a flowchart of an embodiment of a method for calibrating a finite element model using measured data points;

Fig. 4a illustrates measured data points of an object and a simulation of the object;

Fig. 4b illustrates the measured data points of the object and a calibrated simulation of the object; and

Fig. 5 illustrates a flowchart of an embodiment of a method for storing a plurality of simulations.

**Detailed Description**

Various example embodiments will now be described more fully with reference to the accompanying drawings in which some example embodiments are illustrated. In the figures, the thicknesses of lines, layers and/or regions may be exaggerated for clarity.

Accordingly, while further embodiments are capable of various modifications and alternative forms, some example embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the disclosure. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g. "between" versus "directly between", "adjacent" versus "directly adjacent", etc.).

The terminology used herein is for the purpose of describing particular example embodiments only and is not intended to be limiting of further example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art, unless expressly defined otherwise herein.

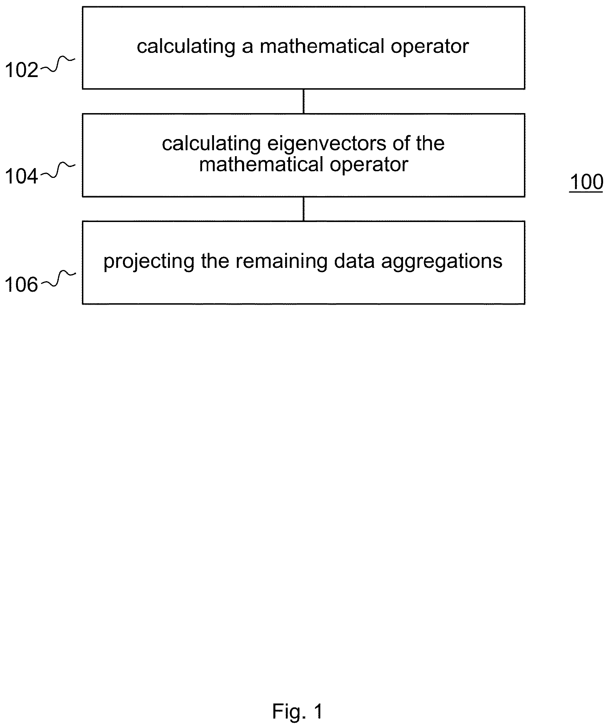

A flowchart of a method 100 for evaluating a plurality of data aggregations is illustrated in **Fig. 1.** A data aggregation comprises a plurality of data points (i.e. two or more data points). In some examples, the plurality of data aggregations may be a plurality of measurement series of at least one sensor for a physical quantity, wherein the plurality of data points represent measurement values of the sensor. For example, the measurement values may represent a temperature, a velocity, an acceleration, a mechanical resistance, a current, a voltage, an electronic resistance, or a position. In some examples, the plurality of data aggregations may be a plurality of simulations of a physical object, wherein the plurality of data points represent numerical solutions of a finite element model of the physical object. For example, the plurality of simulations may represent numerical solutions for different input parameters of the finite element model. However, the proposed concept is not limited to the above examples. In general, any data aggregation comprising a plurality of data points may be used.

The method 100 comprises a first step of calculating 102 a mathematical operator for one of the plurality of data aggregations based on a metric for the data points of the one data aggregation. The metric describes a distance between the individual data points of the one data aggregation, wherein the operator defines a transformation that preserves the metric. For example, the metric may be a Euclidean distance between data points of the one data aggregation. For the data points being nodes of a graph, the metric may be a graph distance between two data points of the one data aggregation. For example, for the data aggregation being a simulation, the metric may be the graph distance on the mesh of the underlying finite element model. In general, the metric may be a geodesic distance, or an approximation thereof, between two data points of the one data aggregation.

The calculated operator preserves the metric, i.e., the metric is invariant to the transformation defined by the operator. In other words, the operator may allow to mutually map the plurality of data aggregations. The operator may be calculated depending on the desired transformation, i.e., the desired invariance.

For example, the transformation may be an isometric transformation, i.e., a transformation that preserves the distance between data points of the aggregation. The isometric transformation may, e.g., be a rotation or a translation. For an isometric transformation, the mathematical operator may, e.g., be a Laplace-Beltrami operator. For example, the Laplace-Beltrami operator on a mesh of a finite element model may be given by

$$L_K^h f(w) = \frac{1}{4\pi h^2} \sum_{t \in K} \frac{Area(t)}{\#t} \sum_{p \in V(t)} e^{-\frac{d(p,w)^2}{4h}} \left( f(p) - f(w) \right) \qquad (1),$$

with L denoting the Laplace-Beltrami operator, f denoting a function on the mesh, #t denoting the number of vertices on t on the mesh, V(t) denoting the set of vertices on t, w being an Element of V(t), d(p, w) denoting the graph distance on the mesh, and h being a parameter that corresponds to the size of the local neighborhood at a point.

For the transformation being a non-linear transformation, i.e., a transformation that is not linear, the mathematical operator may, e.g., be a Non-linear Independent Component Analysis (NICA) operator. For example, the NICA operator may be used for stochastically distributed data points in a data aggregation. It is assumed that there exist non-observable independent statistic processes that get mixed non-linearly through a transformation. The transformed data (i.e. the data aggregation) are observed and it is further assumed that a small ball of stochastic perturbations of the non-observable data gets transformed to small ellipses in the observable data aggregations. Hence, the Jacobian matrix of the transformation and its inverse may be evaluated locally. For example, the assumptions for the NICA operator apply for simulations (as an example for data aggregations) that are obtained by small random variations of input parameters of an underlying finite element model (e.g. slight variations of material parameters in a crash simulation). Another use case may be data measurements of a same physical process under small random stochastic variations. For example, the NICA operator for a set of data points of a data aggregation may be given by

$$L_V^h f(w) = \sum_{p \in U} 1/d(w) e^{-\frac{dNT(p,w)^2}{h}} \left( f(p) - f(w) \right) \qquad (2),$$

with U denoting the set of data points, f being a function defined on U, p and w being elements of U, and h being a parameter that corresponds to the size of the local neighborhood at a data point. In addition, d(w) may be defined as

$$d(w) \equiv \sum_{p \in U} e^{-\frac{dNT(p,w)^2}{h}} \qquad (3).$$

dNT(p, w) denotes a metric that is invariant to a non-linear transformation G. For example, dNT(p, w) may be defined as

$$dNT(p, w) = \frac{1}{2}(e - b)^T \left[ \left( J_G J_G^T \right)^{-1}(e) + \left( J_G J_G^T \right)^{-1}(b) \right] (e - b) \qquad (4),$$

with J denoting the Jacobian matrix of the non-linear transformation G, $J_G J_G^T$ being the local covariance of the data aggregation that is evaluated at each point of the data aggregation. e and b denoting the data points of the data aggregation that are obtained after application of the non-linear transformation G.

For a non-linear transformation, further a Fokker-Planck operator may be calculated. For example, the Fokker-Planck operator may be equal to

$$L_V^h f(w) = \sum_{p \in U} 1/d(w) e^{-\frac{dFK(p,w)^2}{h}} \big(f(p) - f(w)\big) \qquad (5),$$

with U denoting a set of data points, f being a function defined on U, p and w being elements of U, and h being a parameter that corresponds to the size of the local neighborhood at a data point. The expression d(w) may be defined as

$$d(w) \equiv \sum_{p \in U} e^{-\frac{dFK(p,w)^2}{h}} \qquad (6),$$

with dFK(p, w) denoting a metric that is invariant to an isometric transformation and that corresponds to a point based approximation of a geodesic distance measured on a data aggregation. In contrast to a Laplace-Beltrami operator, the Fokker-Planck operator acts on a set of points, not on a mesh. Additionally, a Fokker-Planck operator may generate a basis that is more sensitive to changes in the density of the points.

Moreover, other metrics for the data aggregations may be used. For example, the metric may be affine invariant or conformal invariant. Accordingly, a variety of other operators may be calculated based on these metrics.

The method 100 further comprises calculating 104 eigenvectors of the previously calculated mathematical operator. The eigenvectors may be calculated by solving an Eigenvalue problem of the form

$$A\vec{v} = \lambda\vec{v} \qquad (4),$$

with A denoting a square matrix which represents the mathematical operator, $\lambda$ denoting the eigenvalue (i.e. a scalar value), and $\vec{v}$ denoting the eigenvector.

The eigenvectors are used as basis of a space, and the method 100 further comprises projecting 106 the remaining data aggregations of the plurality of data aggregations into the space spanned by the eigenvectors. A remaining data aggregation of the plurality of remaining data aggregations is projected on the space spanned by the eigenvectors by approximating the remaining data aggregation by a linear combination of the eigenvectors spanning the space. In other words, the remaining data aggregation is approximated by the obtained basis vectors of the space, wherein the coefficients of the linear combination are the representation in the (new) space.

The space may, in some examples, be spanned by all eigenvectors of the mathematical operator. In some examples, the space may be spanned by a subset of all eigenvectors of the mathematical operator. The eigenvectors of the subset may, e.g., satisfy a quality criterion. For example, only eigenvectors having specific eigenvalues may span the space. Specific eigenvalues may be eigenvalues that satisfy a certain criterion. For example, only eigenvectors having high eigenvalues may be used. High eigenvalues may be eigenvalues that are above a certain threshold. For example, the threshold may be defined as an absolute value or as a fraction of the highest values of all eigenvalues (e.g. the highest 30% of all eigenvalues). Eigenvectors having high eigenvalues may allow an accurate approximation of the remaining data aggregations with only a fraction of all eigenvectors since they represent the major contribution to the representation of the remaining data aggregations in the space. Using only a subset of all eigenvectors may allow for reduced computational complexity and, hence, allow for reduced required computational power.

The representation of the data aggregations in the space spanned by the eigenvectors may allow to analyze the data in a space that has a lower dimension than the original space of the data. Accordingly, data analysis may be facilitated. For example, for the data aggregations being measurement series of a sensor, conclusions may be drawn from the distribution of the measurement values in the space spanned by the eigenvectors.

For example, for the data aggregations being simulations on the basis of a finite element model of a physical object (e.g. the finite element model may indicate a deformation of the physical object caused by the exertion of force to the object), effects which depend on the input parameters of the finite element model may be separated based on the structure of the data points in the space spanned by the eigenvectors. For the data aggregations being simulations, information on the space spanned by the eigenvectors may be used as input for optimization algorithms for optimizing input parameters of the finite element model. These algorithms commonly use parameter spaces having a higher dimension than the space spanned by the eigenvectors. For example, restricting the optimization algorithms to parameter regions which correspond to specific regions or structures (e.g. an orbit or a sphere) within the space spanned by the eigenvectors may allow to speed-up the optimization. Further, a computational complexity and a required computational power may be reduced.

The proposed representation of the simulations in the space spanned by the eigenvectors may further allow to classify the plurality of simulations. For example, the plurality of simulations may comprise a subset of simulations for a variation of one or more input parameters. The representation of the simulations in the space spanned by the eigenvectors may allow facilitated detection of theses simulations since they are located on a specific structure (e.g. a sphere) or region within the space spanned by the eigenvectors. For example, independent effect variations like rotations, translations, or distance preserving deformations may be extracted from the plurality of simulations. The extraction may, e.g., be beneficial for crash simulations where one would like to isolate effects and analyze them only with respect to input parameters of the simulation. Moreover, the proposed method may allow to determine pure strains in a deformation by separating rotations and translations from the overall deformation.

Accordingly, also for optimization of these parameters, information on the location of these simulations in the space spanned by the eigenvectors (the location, e.g., providing information in input parameter dependent effects) may allow to restrict search ranges for an optimization algorithm. For example, the optimization algorithm may be restricted to search ranges which correspond to space points in specific regions or structures in the space spanned by the eigenvectors.

In some examples, projecting the remaining data aggregations on the space spanned by the eigenvectors comprises approximating at least one of the remaining data aggregations by a linear combination of a subset of the eigenvectors spanning the space, wherein the subset of the eigenvectors spanning the space satisfies a quality criterion. Using only a subset of the eigenvectors spanning the space again uses the fact that the dominant contribution of the approximation may be achieved by the linear combination of only a few eigenvectors of all the eigenvectors spanning the space. For example, for a higher smoothness of a data aggregation (i.e. for continuous data points within the data aggregation), a lower number of eigenvectors may be required for obtaining an accurate approximation in the space spanned by the eigenvectors. The quality criterion may, e.g., be a spectral coefficient gap within the coefficients of all eigenvectors spanning the space. That is, a spectrum of the coefficients for approximating the remaining data aggregation of all eigenvectors spanning the space is determined, and a gap in the spectrum is determined. Based on the gap in the spectrum, the subset of the eigenvectors spanning the space for the approximation of the remaining data aggregation is determined. Hence, a computational complexity and a required computation power may be further reduced. Additionally, a significant data reduction may be achieved due to the compact representation of the data aggregations as linear combinations of a same basis (i.e. as linear combinations of the same eigenvectors).

For the plurality of data aggregations being simulations, the method may, in some examples, further comprise calculating a synthetic space point in the space by interpolating at least two space points corresponding to the simulations projected into the space. Based on the synthetic space point, a synthetic simulation may be generated using an approximation for the finite element model. Calculating the synthetic space point and generating the synthetic simulation based on the synthetic space point may allow facilitated generation of noncalculated simulations. The synthetic simulation may allow to predict a simulation behavior without the time- and power-consuming process of actually generating the simulation. For example, an engineer may determine the behavior of a simulation for an input parameter variation of the underlying finite element model by calculating a respective space point by interpolation of space points of previously calculated simulations, and by approximating the simulation using the synthetic space point. The synthetic simulation may allow the engineer to at least roughly analyze / estimate the effect of the input parameter variation without the time-consuming generation of a real simulation. Hence, a required time and a required computing power may be reduced.

In summarizing the above concept for simulations, the data analysis challenge may be addressed by using a mathematical construction which relies on the principles of symmetry.

The engineering data may be understood as a complex geometrical object. For example, each simulation being obtained by different specific model variations may be understood as the result of a transformation of only one reference configuration. Hence, the simulations may be parameterized on a lower dimensional space (orbit space of transformations). For parametrization, one simulation from a given a set of simulations may be fixed as a reference. For the given reference simulation a (e.g. positive definitive discrete) operator may be evaluated. Therefore a distance metric for the points in the reference simulation may be chosen. This distance should impose an invariant property (e.g. a graph distance may be used as an approximation of the geodesic distance on the reference simulation). This distance is invariant to pose changes (i.e. distance preserving deformations). Other types of transformations may also be possible for appropriately defined distance (metric). This distance (metric) may be used to construct a (e.g. positive definitive discrete) operator. The spectral decomposition for the operator may be calculated and used as a basis. The basis may be an invariant space. The invariance property depends on the chosen metric. The given set of simulations may be projected into this unique basis. As a result of this step, a set of coefficients may be obtained (orbit coordinates). Only few coefficients may be big depending on the smoothness of the given set of simulations so that those coefficients actually represent a low dimensional approximation of the space of orbits. The effects of parameter variations along such spaces of orbits may be analyzed since they can be separated and identified along such coordinates.

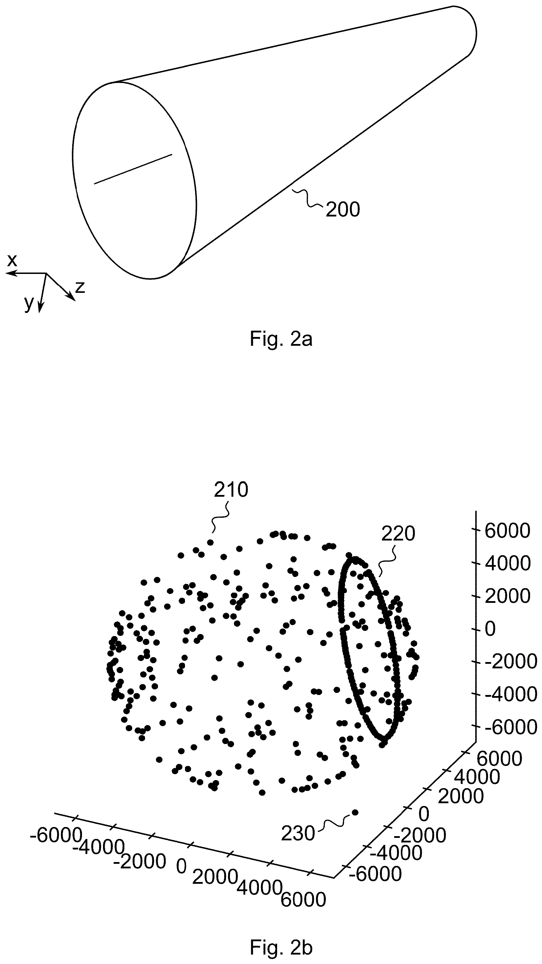

From **Figs. 2a and 2b** the effect of the proposed method will become more evident. Fig. 2a illustrates a three-dimensional simulation of cylinder 200 as an example of a data aggregation. The cylinder 200 is built of a mesh of 9000 nodes (i.e. numerical solutions of an underlying finite element model) and, hence, 9060 area elements. Assuming that a differential equation of the underlying finite element model has only solutions which describe arbitrary rotations of the cylinder 200 in the three-dimensional Euclidean space, solving the finite element model (i.e. the differential equation) generates a specific spatial rotation of the cylinder 200 in the three-dimensional Euclidean space.

For example, the graph distance between two nodes of the cylinder may be selected as metric for the simulation. The graph distance is invariant to isometric transformations (i.e. also to rotations). A mathematical operator may now be defined that preserves the metric (e.g. a Laplace-Beltrami operator). Eigenvectors of the operator are then calculated and a space is spanned by the eigenvectors.

The projection of 300 arbitrarily rotated cylinders on the space spanned by the eigenvectors is illustrated in Fig. 2b. As illustrated in Fig. 2b, the space is a sphere 210 since all possible rotations of the cylinder 200 may be described by the angles with respect to the three spacial axes of the three-dimensional Euclidean space. Hence, all rotated cylinders are located on the surface of the sphere 210, wherein each data point corresponds to a specific angle combination. The sphere 210 represents a low-dimensional space of all possible cylinder mesh objects.

Regarding data point 230, which is not located on the surface of the sphere 210, a user (e.g. an engineer) may recognize that the simulation corresponding to data point 230 does not only involve a variation of the input parameters causing a rotation of the cylinder in the three-dimensional Euclidean space but also a scaling of the cylinder. Accordingly, when the user wants to study merely the effects of the rotations, he / she may be able to identify the simulation corresponding to data point 230 and focus merely on the other simulations on the surface of the sphere 210 for analysis. In other words, the representation of the cylinders (i.e. the simulations) in the space spanned by the eigenvectors may allow to select only valid simulations for the analysis from the plurality of simulations.

The circle 220 illustrates simulations where only one of the three angles with respect to the spacial axes of the three-dimensional Euclidean space is varied, whereas the other two angles are fixed. Identifying structures like the circle 220 may allow to analyze the behavior of the simulation under specific parameter changes.

Moreover, synthetic space points may be generated by interpolating two or more space points on the sphere 210. As discussed above, the synthetic space points may be used to generate synthetic simulations using an approximation for the underlying finite element model. For example, synthetic space points on the circle 220 may be calculated by interpolating other space points of the circle 220. Hence, synthetic simulations may be generated which correspond to variations of the one angle with respect to the three-dimensional Euclidean space. Accordingly, a user may include the synthetic simulations into the analysis in order to be able to perform at least a rough analysis of effects caused by the rotation of the cylinder along the one spacial axis of the three-dimensional Euclidean space.

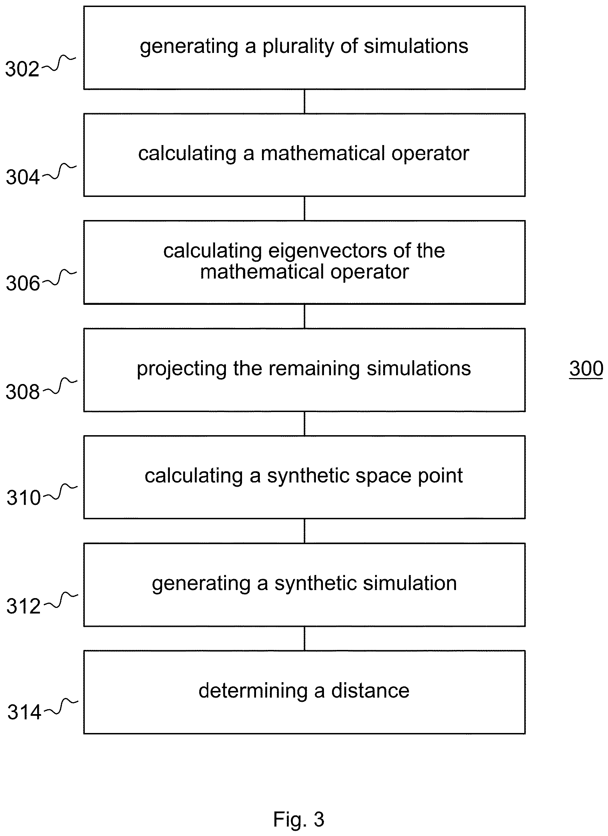

Another embodiment of the proposed concept is illustrated in Fig. 3. Fig. 3 illustrates a method 300 for calibrating a finite element model of a physical object (e.g. a crash simulation, i.e., the finite element model may indicate a deformation of the physical object caused by the exertion of force to the object) using measured data points. The finite element model may be used to generate simulations for studying the behavior of one or more structural elements. However, the conditions of the experimental set-up providing the measured data points are commonly different from the calculated simulations. For example, material parameters, load conditions, or geometrical dimensions of structural elements may differ from the assumptions used for the simulations. Hence, calibration of the finite element model is required.

Therefore, the method 300 comprises as a first step of generating 302 a plurality of simulations of the physical object using the finite element model based on varying sets of input parameters. As described above, a simulation comprises a plurality of data points representing numerical solutions of the finite element model. In other words, the finite element model is solved for varying input parameters.

Further, the method comprises calculating 304 a mathematical operator for one of the plurality of simulations based on a metric for the data points of the one simulation, wherein the operator defines a transformation that preserves the metric. For example, the transformation may be an isometric transformation, and the mathematical operator may be a Laplace-Beltrami operator as described above. In some examples, the transformation may be a non-linear transformation, and the mathematical operator may be a NICA operator or a Fokker-Planck operator. However, any kind of transformation may be used together with an appropriately defined operator.

The method 300 comprises calculating 306 eigenvectors of the mathematical operator, and projecting 308 the remaining simulations of the plurality of simulations into a space spanned by the eigenvectors. As described above, the space may be spanned by all eigenvectors of the mathematical operator, or a subset of all eigenvectors. The eigenvectors of the subset may satisfy a quality criterion (see, e.g., the above examples). Moreover, projecting a simulation of the remaining simulations may be done by approximating the simulation by a linear combination of a subset of the eigenvectors spanning the space (e.g. also a subset of the subset of eigenvectors) as described above. The subset of the eigenvectors spanning the space may satisfy a quality criterion (see, e.g., the above examples).

Further, the method 300 comprises calculating 310 a synthetic space point in the space by interpolating at least two space points corresponding to the simulations projected into the space. By calculating the synthetic space point, input parameter variations for the finite element model may be put into practice. Based on the synthetic space point, the method 300 further comprises generating 312 a synthetic simulation using an approximation for the finite element model. In other words, a synthetic simulation is generated based on the varied input parameter(s).

The method 300 comprises determining 314 a distance between the synthetic simulation and the measured data points in the space of the measured data points, i.e., not in the space spanned by the eigenvectors. Based on the determined distance, one may determine whether or not the generated synthetic simulation fits the measured data points. For example, a quality criterion may be defined for the above decision. The quality criterion may, e.g., be a maximum distance between the measured data points and the synthetic simulation. Therefore, calculating 310 a synthetic space point in the space, generating 312 a synthetic simulation and determining 314 a distance between the synthetic simulation and the measured data points may be carried out iteratively until the determined distance satisfies the quality criterion. Accordingly, a synthetic simulation may be determined which fits to the measured data points. Thus, enabling calibration of the finite element model. Moreover, the synthetic space point of the determined best synthetic simulation may be analyzed with respect to the previously generated simulations. For example, the analysis may allow conclusions for optimized input parameters for the finite element model.

In other words, a comparison of simulations and experiments may be enabled by the above method. This is a difficult subject in an industrial context since a simulation contains many assumptions that are not necessarily reflected in a real scenario. For example it is very difficult to apply a load to an object exactly symmetric at some point with respect to some axis. However, this is a common assumption for simulations. The proposed method may inter alia allow to reveal input parameter changes in the finite element model which emulate variations observed in real data / observations.

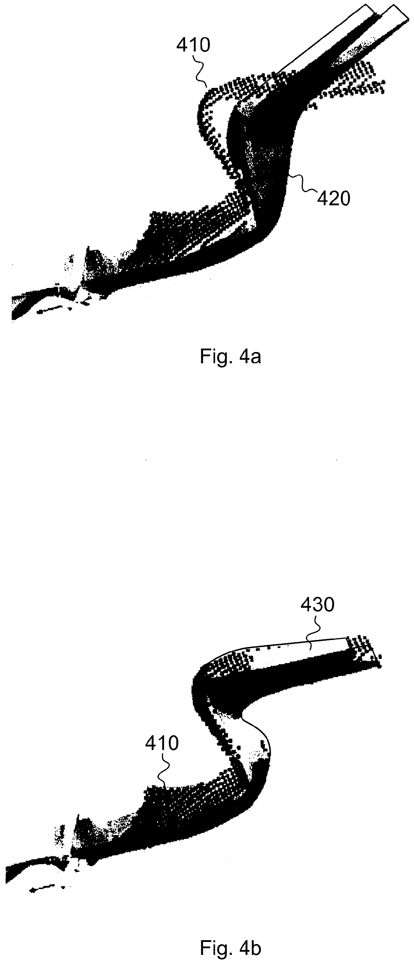

An example using the above described finite element model calibration is illustrated in Figs. 4a and 4b. Measured data points 410 for a component of a car in a crash test are illustrated in Fig. 4a. Additionally, a simulation 420 of the component, which is based on a finite element model, is illustrated in Fig. 4a. As can be seen from Fig. 4a, the obtained simulation 420 does not perfectly model the measured data point 410 for the object. In other words, the finite element model is not calibrated.

The effect of calibrating the finite element model according to method 300 is illustrated in Fig. 4b. Fig. 4b illustrates again the measured data points 410 for the component of the car. Additionally, Fig. 4b illustrates a synthetic simulation 430 generated using an approximation for the finite element model based on a synthetic space point in accordance with method 300. Therefore, 116 simulations were created by varying the thickness of ten parts in structural components of the finite element model of the car. Additionally, a NICA operator was calculated for one simulation, and the basis of the NICA operator was determined by solving an eigenvalue problem. The synthetic space point was calculated in the space spanned by the basis of the NICA operator by extrapolating space points relating to some of the 116 generated simulations. It is obvious form Fig. 4b that the generated synthetic simulation 430 accurately models the measured data points 410. In other words, the measure date point 410 are aligned with the synthetic simulation 430. Hence, the underlying finite element model is calibrated using real data.

For determining the distance of the simulation 420, or the synthetic simulation 430 to the measured data point 410 one may further take into account the camera angle used for recording the measured data points 410. Accordingly, when determining the distance to the measure data points 410, the synthetic simulation 430 may be projected into the space of the measure data points 410 using the same camera angle as for recording the measured data points.

In other words, experimental results from an experimental tests in the form of point clouds, and a finite element model that can be solved for different model parameters combinations may be used as input for the proposed method. A synthetic simulation which corresponds to the experimental test, and a space for the simulations where the specific synthetic simulation can be located and be analyzed with respect to spheres / orbits of independent variations and input parameters variations may be obtained from the proposed method.

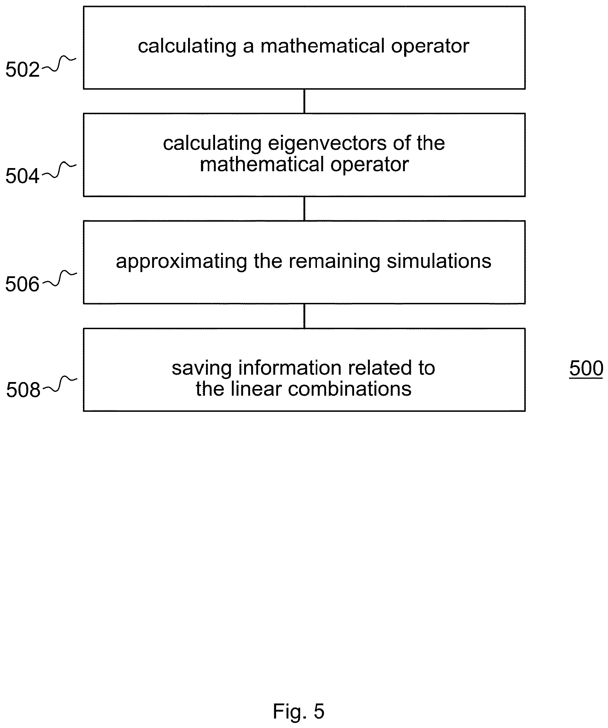

Another embodiment of the proposed concept is illustrated in Fig. 5. Fig. 5 illustrates a method 500 for storing a plurality of simulations of a physical object. Again, a simulation comprises a plurality of data points (i.e. at least two data points) representing numerical solutions of a finite element model of the physical object (e.g. the finite element model may indicate a deformation of the physical object caused by the exertion of force to the object).

Similar to the above methods, the method 500 comprises a step 502 of calculating a mathematical operator for one of the plurality of simulations based on a metric for the data points of the one simulation, wherein the operator defines a transformation that preserves the metric. For example, the transformation may be an isometric transformation, and the mathematical operator may be a Laplace-Beltrami operator as described above. In some examples, the transformation may be a non-linear transformation, and the mathematical operator may be a NICA operator or a Fokker-Planck operator. However, any kind of transformation may be used together with an appropriately defined operator.

The method further comprises calculating 504 eigenvectors of the mathematical operator and approximating 506 the remaining simulations by linear combinations of the eigenvectors. As described above, all eigenvectors of the mathematical operator may be used for the approximation, or a subset of all eigenvectors. The eigenvectors of the subset may satisfy a quality criterion (see, e.g., the above examples).

Furthermore, the method 500 comprises saving 508 information related to the linear combinations to a memory (e.g. a hard disk, a solid-state drive or a magnetic data storage). For example, the information related to the linear combinations may comprise the respective coefficients of the eigenvectors for at least one of the linear combinations. In other words, the plurality of simulations may be stored by saving a single set of eigenvectors and the respective coefficients of the simulations with respect to the eigenvectors. Hence, a data amount of a simulation may be compressed significantly for storage. Accordingly, a required memory space for storing the plurality of simulations may be reduced. In contrast, an increased number of simulations may be stored to a given amount of memory space.

In some embodiments, the data points of a first simulation of the remaining simulations and the data points of a second simulation of the remaining simulations may represent the numerical solutions of the finite element model for a same set of input parameters at a first time instant and a different second time instant, respectively. That is, for the same set of input parameters, multiple simulations corresponding to different instances in time may be saved to memory using the same basis of eigenvectors. Hence, the temporal evolutions for different sets of input parameters may be stored to memory in a compressed manner using the proposed concept. In other words, the proposed concept may allow to efficiently save temporal evolutions for different sets of input parameters to a memory due to the representation of the simulations as linear combinations of the basis of eigenvectors.

In other words, some examples relate to a method for storing a plurality of simulations of a physical object, wherein a simulation comprises a plurality of data points representing numerical solutions of a finite element model of the physical object. The method comprises calculating a mathematical operator for one of the plurality of simulations based on a metric for the data points of the one simulation, the operator defining a transformation that preserves the metric. Further the method comprises calculating eigenvectors of the mathematical operator, and approximating the remaining simulations by linear combinations of the eigenvectors. The method further comprises saving, to a memory, information related to the linear combinations. In some examples, the data points of a first simulation of the remaining simulations and the data points of a second simulation of the remaining simulations represent the numerical solutions of the finite element model at a first time instant and a different second time instant using the same set of input parameters. The information related to the linear combinations comprises, in some examples, respective coefficients of the eigenvectors for at least one of the linear combinations.

Example embodiments may further provide a computer program having a program code for performing one of the above methods, when the computer program is executed on a computer or processor. A person of skill in the art would readily recognize that steps of various above-described methods may be performed by programmed computers. Herein, some example embodiments are also intended to cover program storage devices, e.g., digital data storage media, which are machine or computer readable and encode machine-executable or computer-executable programs of instructions, wherein the instructions perform some or all of the acts of the above-described methods. The program storage devices may be, e.g., digital memories, magnetic storage media such as magnetic disks and magnetic tapes, hard drives, or optically readable digital data storage media. Further example embodiments are also intended to cover computers programmed to perform the acts of the above-described methods or (field) programmable logic arrays ((F)PLAs) or (field) programmable gate arrays ((F)PGAs), programmed to perform the acts of the above-described methods.

The description and drawings merely illustrate the principles of the disclosure. It will thus be appreciated that those skilled in the art will be able to devise various arrangements that, although not explicitly described or shown herein, embody the principles of the disclosure and are included within its scope. Furthermore, all examples recited herein are principally intended expressly to be only for pedagogical purposes to aid the reader in understanding the principles of the disclosure and the concepts contributed by the inventor(s) to furthering the art, and are to be construed as being without limitation to such specifically recited examples and conditions. Moreover, all statements herein reciting principles, aspects, and embodiments of the disclosure, as well as specific examples thereof, are intended to encompass equivalents thereof.

Functional blocks denoted as "means for ..." (performing a certain function) shall be understood as functional blocks comprising circuitry that is configured to perform a certain function, respectively. Hence, a "means for s.th." may as well be understood as a "means configured to or suited for s.th.". A means configured to perform a certain function does, hence, not imply that such means necessarily is performing the function (at a given time instant). Functions of various elements shown in the figures, including any functional blocks labeled as "means", "means for providing a sensor signal", "means for generating a transmit signal.", etc., may be provided through the use of dedicated hardware, such as "a signal provider", "a signal processing unit", "a processor", "a controller", etc. as well as hardware capable of executing software in association with appropriate software. Moreover, any entity described herein as "means", may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the disclosure. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the detailed description, where each claim may stand on its own as a separate example embodiment. While each claim may stand on its own as a separate example embodiment, it is to be noted that - although a dependent claim may refer in the claims to a specific combination with one or more other claims - other example embodiments may also include a combination of the dependent claim with the subject matter of each other dependent or independent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective acts of these methods.

Further, it is to be understood that the disclosure of multiple acts or functions disclosed in the specification or claims may not be construed as to be within the specific order. Therefore, the disclosure of multiple acts or functions will not limit these to a particular order unless such acts or functions are not interchangeable for technical reasons. Furthermore, in some embodiments a single act may include or may be broken into multiple sub acts. Such sub acts may be included and part of the disclosure of this single act unless explicitly excluded.

## Claims

1. A computer executed method (300) for calibrating a finite element model using measured data points, wherein the finite element model indicates a deformation of a physical object caused by the exertion of force to the physical object, the method comprising:

   generating (302) a plurality of simulations of the physical object using the finite element model based on varying sets of input parameters, a simulation comprising a plurality of data points representing numerical solutions of the finite element model;
   calculating (304) a mathematical operator for one of the plurality of simulations based on a metric for the data points of the one simulation, the mathematical operator defining a transformation that preserves the metric, the metric describing a distance between the individual data points of the one simulation;
   calculating (306) eigenvectors of the mathematical operator;
   projecting (308) the remaining simulations of the plurality of simulations into a space spanned by the eigenvectors;
   calculating (310) a synthetic space point in the space by interpolating at least two space points corresponding to the simulations projected into the space;
   generating (312) a synthetic simulation using an approximation for the finite element model based on the synthetic space point; and
   determining (314) 2. the distance between the synthetic simulation and the measured data points, wherein either a) the transformation is an isometric transformation and the mathematical operator is a Laplace-Beltrami operator or b) the transformation is a non-linear transformation and the mathematical operator is a non-linear independent component analysis operator or a Fokker-Planck operator, and
   wherein calculating (310) the synthetic space point in the space, generating (312) the synthetic simulation and determining (314) the distance between the synthetic simulation and the measured data points is carried out iteratively until the determined distance satisfies a quality criterior so as to enable calibration of the finite element model

2. The computer executed method of claim 1, wherein the space is spanned by a subset of all eigenvectors, the eigenvectors of the subset satisfying another quality criterion.

3. The computer executed method of claim 1 or claim 2, wherein projecting (308) the remaining simulations of the plurality of simulations into the space spanned by the eigenvectors comprises approximating at least one of the remaining simulations by a linear combination of the subset of the eigenvectors spanning the space, the subset of the eigenvectors spanning the space satisfying another quality criterion.

4. A computer program having a program code configured to perform the method of any one of claims 1 to 3, when the computer program is executed on a computer or processor.

**Patentansprüche**

1. Ein computerausgeführtes Verfahren (300) zum Kalibrieren eines Finite-Elemente-Modells unter Verwendung gemessener Datenpunkte, wobei das Finite-Elemente-Modell eine Verformung eines physikalischen Objekts anzeigt, die durch die Ausübung von Kraft auf das physikalische Objekt verursacht wird, wobei das Verfahren umfasst:

   Erzeugen (302) einer Mehrzahl von Simulationen des physikalischen Objekts unter Verwendung des Finite-Elemente-Modells basierend auf variierenden Sätzen von Eingabeparametern, wobei eine Simulation eine Mehrzahl von Datenpunkten umfasst, die numerische Lösungen des Finite-Elemente-Modells darstellen;
   Berechnen (304) eines mathematischen Operators für eine der Mehrzahl von Simulationen basierend auf einer Metrik für die Datenpunkte der einen Simulation, wobei der mathematische Operator eine Transformation definiert, die die Metrik beibehält, wobei die Metrik eine Distanz zwischen den einzelnen Datenpunkten der einen Simulation beschreibt;
   Berechnen (306) der Eigenvektoren des mathematischen Operators;
   Projizieren (308) der verbleibenden Simulationen der Mehrzahl von Simulationen in einen von den Eigenvektoren aufgespannten Raum;
   Berechnen (310) eines synthetischen Raumpunktes in dem Raum durch Interpolieren von zumindest zwei Raumpunkten, die den in den Raum projizierten Simulationen entsprechen;
   Erzeugen (312) einer synthetischen Simulation unter Verwendung einer Näherung für das Finite-Elemente-Modell basierend auf dem synthetischen Raumpunkt; und
   Bestimmen (314) der Distanz zwischen der synthetischen Simulation und den gemessenen Datenpunkten, wobei entweder a) die Transformation eine isometrische Transformation ist und der mathematische Operator ein Laplace-Beltrami-Operator ist oder b) die Transformation eine nichtlineare Transformation ist und der mathematische Operator ein Nichtlineare-Unabhängige-Komponentenanalyse-Operator oder ein Fokker-Planck-Operator ist, und
   wobei das Berechnen (310) des synthetischen Raumpunkts in dem Raum, das Erzeugen (312) der synthetischen Simulation und das Bestimmen (314) der Distanz zwischen der synthetischen Simulation und den gemessenen Datenpunkten iterativ durchgeführt wird, bis die bestimmte Distanz ein Qualitätskriterium erfüllt, um die Kalibrierung des Finite-Elemente-Modells zu ermöglichen.

2. Das computerausgeführte Verfahren gemäß Anspruch 1, wobei der Raum von einer Teilmenge aller Eigenvektoren aufgespannt wird, wobei die Eigenvektoren der Teilmenge ein anderes Qualitätskriterium erfüllen.

3. Das computerausgeführte Verfahren gemäß Anspruch 1 oder Anspruch 2, wobei das Projizieren (308) der verbleibenden Simulationen der Mehrzahl von Simulationen in den von den Eigenvektoren aufgespannten Raum ein Annähern zumindest einer der verbleibenden Simulationen durch eine Linearkombination der den Raum aufspannenden Teilmenge der Eigenvektoren umfasst, wobei die den Raum aufspannende Teilmenge der Eigenvektoren ein anderes Qualitätskriterium erfüllt.

4. Ein Computerprogramm mit einem Programmcode, der ausgebildet ist zum Durchführen des Verfahrens gemäß einem der Ansprüche 1 bis 3, wenn das Computerprogramm auf einem Computer oder Prozessor ausgeführt wird.

**Revendications**

1. Méthode exécutée par ordinateur (300) pour étalonner un modèle d'éléments finis en utilisant de points de données mesurés, dans lequel le modèle d'éléments finis indique une déformation d'un objet physique causée par la force appliquée à l'objet physique, la méthode comprenant le fait de :

   générer (302) une pluralité de simulations de l'objet physique en utilisant le modèle d'éléments finis sur la base des ensembles variables de paramètres d'entrée, une simulation comprenant une pluralité de points de données représentant des solutions numériques du modèle d'éléments finis ;
   calculer (304) un opérateur mathématique pour l'une de la pluralité de simulations sur la base d'une métrique pour les points de données de l'une simulation, l'opérateur mathématique définissant une transformation qui préserve la métrique, la métrique décrivant une distance entre les points de données individuels de l'une simulation;
   calculer (306) les vecteurs propres de l'opérateur mathématique ;
   projeter (308) les simulations restantes de la pluralité de simulations dans un espace couvert par les vecteurs propres ;

calculer (310) un point d'espace synthétique dans l'espace en interpolant au moins deux points d'espace correspondant aux simulations projetées dans l'espace ;

générer (312) une simulation synthétique en utilisant une approximation pour le modèle d'éléments finis sur la base du point d'espace synthétique ; et

déterminer (314) la distance entre la simulation synthétique et les points de données mesurés ;

dans lequel soit a) la transformation est une transformation isométrique et l'opérateur mathématique est un opérateur de Laplace-Beltrami soit b) la transformation est une transformation non linéaire et l'opérateur mathématique est un opérateur d'analyse de composante indépendante non linéaire ou un opérateur de Fokker-Planck, et

dans lequel le fait de calculer (310) le point d'espace synthétique dans l'espace, le fait de générer (312) la simulation synthétique et le fait de déterminer (314) la distance entre la simulation synthétique et les points de données mesurés sont effectués de manière itérative jusqu'à ce que la distance déterminée satisfasse un critère de qualité de manière à permettre l'étalonnage du modèle d'éléments finis.

2. Méthode exécutée par ordinateur selon la revendication 1, dans lequel l'espace est couvert par un sous-ensemble de tous les vecteurs propres, les vecteurs propres du sous-ensemble satisfaisant un autre critère de qualité.

3. Méthode exécutée par ordinateur selon la revendication 1 ou la revendication 2, dans lequel le fait de projeter (308) les simulations restantes de la pluralité de simulations dans l'espace couvert par les vecteurs propres comprend le fait d'approximer au moins une des simulations restantes par une combinaison linéaire du sous-ensemble des vecteurs propres couvrant l'espace, le sous-ensemble des vecteurs propres couvrant l'espace satisfaisant un autre critère de qualité.

4. Programme d'ordinateur présentant un code de programme configuré pour effectuer le procédé selon l'une des revendications 1 à 3, lorsque le programme d'ordinateur est exécuté sur un ordinateur ou processeur.

Fig. 1

Fig. 2a

Fig. 2b

302 — generating a plurality of simulations

304 — calculating a mathematical operator

306 — calculating eigenvectors of the mathematical operator

308 — projecting the remaining simulations

300

310 — calculating a synthetic space point

312 — generating a synthetic simulation

314 — determining a distance

Fig. 3

Fig. 4a

Fig. 4b

502 — calculating a mathematical operator

504 — calculating eigenvectors of the mathematical operator

506 — approximating the remaining simulations

508 — saving information related to the linear combinations

500

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **RODRIGO IZA TERAN.** Enabling the analysis of finite element simulation bundles. *International Journal of Uncertainty Quantification,* 2014, 95-110